# EUROPEAN PATENT APPLICATION

(11) **EP 4 808 342 A2**
(43) Date of publication of application: **16.09.2026**
(21) Application number: 26162040.5
(22) Date of filing: 03.03.2026
(51) Int. Cl.: H10W 90/22, H10W 42/00, H10W 70/60, H10W 70/685, H10W 90/10

(54) **DIE FOR WARPAGE CONTROL IN SEMICONDUCTOR PACKAGES**

(30) Priority: 05.03.2025 US 202519071269
(71) Applicant: Avago Technologies International Sales Pte. Limited, Singapore 768923 (SG)
(72) Inventor: Wang, Tao, Los Gatos, 85032 (US)
(74) Representative: Dilg, Haeusler, Schindelmann Patentanwaltsgesellschaft mbH

(57) **Abstract**

The subject technology is directed to semiconductor devices and fabrication methods thereof. In an embodiment, the subject technology provides an apparatus that includes a functional die coupled to a first side of a substrate and a second die coupled to a second side of the substrate opposite the first side. The second die is at least one of (1) about a same thickness as the first die, (2) about a same area as the first die, (3) in about a same location as the first die, or (4) formed from a similar material as the first die. Providing the second die on the second side of the substrate counterbalances the thermomechanical stresses or forces produced by the first die. Thus, reducing the stresses on the substrate than can cause misalignment between semiconductor components or electrical failures. There are other embodiments as well.

## Description

### FIELD OF INVENTION

The subject technology is directed to semiconductor devices.

### BACKGROUND OF THE INVENTION

Semiconductor packages are essential components that provide both physical support and electrical connectivity for integrated circuits. They protect the circuits from environmental factors and facilitate the routing of electrical signals between the circuits and external systems. As electronic devices continue to evolve, there is a growing demand for semiconductor packages that can accommodate high-power applications and higher levels of integration. These applications often necessitate larger package sizes to house complex circuitry and multiple interconnected components, placing greater demands on the structural and thermal performance of the substrates used in these packages.

Some semiconductor packages may utilize stiffener rings or lids to add rigidity to and maintain the flatness of the substrate package. However, these semiconductor packages typically lack the mechanical stiffness and thermal conductivity needed for advanced applications, particularly in large-scale packages. Warpage and mechanical instability can occur, especially when there are significant thermal stresses or mismatches in the coefficients of thermal expansion (CTE) between different materials in the package. Such mechanical instability can lead to misalignment of components and potential electrical failures.

Various approaches for mitigating warpage and improving the mechanical stability of semiconductor packages have been explored, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a simplified diagram illustrating a cross-sectional view of a portion of a semiconductor device according to embodiments of the subject technology.
Figure 2A is a simplified diagram illustrating a top view of a first embodiment of a functional die of the semiconductor device according to embodiments of the subject technology.
Figure 2B is a simplified diagram illustrating a top view of a first embodiment of a second die of the semiconductor device according to embodiments of the subject technology.
Figure 3A is a simplified diagram illustrating a top view of a second embodiment of a functional die of the semiconductor device according to embodiments of the subject technology.
Figure 3B is a simplified diagram illustrating a top view of a second embodiment of a second die of the semiconductor device according to embodiments of the subject technology.
Figure 4 is a simplified diagram illustrating a cross-sectional view of a portion of a semiconductor device according to embodiments of the subject technology.
Figure 5 is a simplified diagram illustrating a cross-sectional view of a semiconductor device according to embodiments of the subject technology.
Figure 6 is a simplified diagram illustrating a cross-sectional view of a semiconductor device according to embodiments of the subject technology.
Figure 7 is a simplified diagram illustrating a cross-sectional view of a portion shown in a dashed rectangle of Figure 5 of a semiconductor device according to embodiments of the subject technology.
Figure 8 is a simplified block diagram illustrating a method to form a semiconductor device according to embodiments of the subject technology.

### DETAILED DESCRIPTION OF THE INVENTION

The subject technology is directed to semiconductor devices and fabrication methods thereof. In an embodiment, the subject technology provides an apparatus that includes a functional die coupled to a first side of a substrate and a second die coupled to a second side of the substrate opposite the first side. The second die is at least one of (1) about a same thickness as the first die, (2) about a same area as the first die, (3) in about a same location as or overlaps the first die, or (4) formed from a similar material as the first die. Providing the second die on the second side of the substrate counterbalances the thermomechanical stresses or forces produced by the first die. Thus, reducing the stresses on the substrate that can cause misalignment between semiconductor components or electrical failures. There are other embodiments as well.

Semiconductor packages are increasingly requiring more functionality which places greater demand on the structural and thermal performance of the substrates used in these packages. Coefficient of thermal expansion mismatch between one or more functional dies on a surface of a packaging substrate fundamentally create warpage and internal stress during temperature changes within the semiconductor package. This warpage can cause the substrates within the package to deform and potentially lead to misalignment of components and potential electrical failures.

Several approaches have been explored to address these challenges. As previously noted, stiffener rings or lids are widely used to provide mechanical support to a semiconductor package. These stiffener rings or lids are located on a same side of a packaging substrate as a functional die and oppose the deformation of the packaging substrate to flatten the packaging substrate. However, such flattening acts as a constraint preventing the packaging substrate to freely warp. This causes additional internal stress within the packaging substrate. Thus, there is a conflict between controlling the warpage of the packaging substrate by applying more flattening force to ensure the very large size packaging substrate is surface mountable to a circuit board and reducing the internal stress within the packaging substrate by applying less flattening force to ensure all internal stress and strain levels are within limits demanded by component reliability requirements. Additionally, the stiffener ring or lid often takes up valuable space on a top surface of a packaging substrate which could be used to connect to additional integrated circuits or additional dies. Thus, there is a need to reduce warpage of the packaging substrate while also reducing internal stress within the packaging substrate and a need to provide more space on a packaging substrate for more integrated circuits or dies.

In various embodiments, the subject technology provides semiconductor devices that include a second die coupled to a second side of a packaging substrate. The second side of the packaging substrate is opposite to a first side of the packaging surface coupled to a functional die. The second die is about a same thickness or about a same area as the functional die on the first surface of the packaging substrate. The use of the second die coupled to the second side of the packaging substrate enhances the mechanical stability of semiconductor package, enabling the production of larger packages (e.g., exceeding 100 mm x 100 mm) without compromising manufacturability. The second die minimizes deformation of the packaging substrate under thermal and mechanical stresses, maintaining the alignment and reliability of package components. Additionally, the use of the second die on the second side of the packaging substrate means that a smaller stiffener ring could be used on the first side of the packaging substrate or that no stiffener ring could be used on the first side of the packaging substrate. This frees up valuable space on the first side of the packaging substrate to include additional integrated circuits, functional dies, or other components.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, a dielectric layer may comprise multiple dielectric materials or multiple layers of dielectric materials, a device layer can include one or more resistors, capacitors, inductors, diodes, transistors, integrated circuits, etc. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Additionally, when referring to electrical connection elements within a semiconductor package and/or for chip-to-chip or chip-to-board bonding, a "via" is a vertical, cylindrical structure that can provide electrical connections through a substrate. A via is typically taller than it is wide. Vias provide high-density interconnects and reduce the footprint required for electrical connections. Vias primarily serve as interconnects for electrical and thermal conduction between different layers or components within a semiconductor device or package. In various cases, a via may extend completely through a substrate (e.g., a "through substrate" via (TSV)), may extend through a portion of a substrate from one outer surface (e.g., a "blind" via), or may extend through a portion of the substrate and be completely hidden from external view (e.g., a "buried" via), and/or the like. As used herein, "pad" is referred to as a flat, planar area on the substrate. A pad is typically wider than it is tall and has a larger surface area. It is primarily used as a contact area or a landing pad for wire bonding, soldering, or other bonding techniques. Copper pads are widely used in various semiconductor packaging processes, including traditional wire bonding, tape automated bonding (TAB), and flip-chip bonding. Further, "bump", for example a copper, aluminum, nickel, or titanium, or the like bump, also known as solder bump or micro-bump, is a structure used for interconnection in semiconductor packaging. A bump may be based on a via or a pad. "Bumps" are commonly used in various semiconductor packaging technologies, including flip-chip bonding and chip-to-chip interconnections.

Additionally, when an element is referred to herein as being a "circuit," a circuit is commonly recognized as a building block of modern electronics. Circuits are composed of various electronic components such as resistors, capacitors, inductors, diodes, transistors, integrated circuits, etc. In some cases, circuits can also include optical components or other components. Integrated circuits can be formed from one or more circuits. These electronic components, optical components, or other components are carefully selected and interconnected to create a circuit that can perform a specific task or carry out a particular function. Circuits can be categorized into different types based on their purpose or function, including amplifiers, oscillators, filters, power supplies, logic gates, photonic circuits, among others.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components. Additionally, use of the terms first, second, third, etc. are used for purposes of explanation only and to distinguish elements from one another. They are not intended to recite a certain order unless expressly stated in this disclosure.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." Unless otherwise specified or limited, the terms 'about' and 'approximately,' as used herein with respect to a reference value, refer to variations from the reference value of ± 30% or less (e.g., ± 30%, ± 25%, ± 20%, ± 15%, ± 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In a first aspect, an apparatus can include a packaging substrate comprising a first side and a second side opposite the first side, a first die coupled to the first side of the packaging substrate, the first die comprising a first thickness and a first area, and a second die coupled to the second side of the packaging substrate, the second die comprising a second thickness and a second area. In some cases, the second die on the second side of the packaging substrate overlaps at least a portion of the first die on the first side of the packaging substrate, the first thickness of the first die is about a same thickness as the second thickness of the second die, and the first area of the first die is about a same area as the second area of the second die.

In some cases, the first die and the second die are formed from a same material. In some instances, the first die and the second die are at least one of formed from a material having about a same average coefficient of thermal expansion or formed from a material having at least of about a same average Young's modulus.

In various cases, the second die on the second side of the packaging substrate overlaps at least 70% of the first die on the first side of the packaging substrate.

In various instances, the second die comprises one or more vias. In some cases, the first die is coupled to the packaging substrate via a first connection, the second die is coupled to the packaging substrate via a second connection, and the first connection and the second connection are about a same size. In some instances, the first connection is encapsulated in a first molding material, the second connection is encapsulated in a second molding material, and the second molding material is about a same size as the first molding material.

In some instances, the first die is coupled to the packaging substrate via a first connection, the second die is coupled to the packaging substrate via a second connection, and the first connection is located in about a same location as the second connection.

In various cases, the second die is separated into multiple parts. In other cases, the second die is formed of a unitary part.

In some examples, the first die is formed of single crystalline silicon and the second die is formed of single crystalline silicon or polycrystalline silicon.

In another aspect, an apparatus can include a packaging substrate comprising a first side and a second side opposite the first side, a first die coupled to the first side of the packaging substrate, the first die comprising a first thickness, and a second die coupled to the second side of the packaging substrate, the second die comprising a second thickness. In some cases, the second thickness of the second die is about 70 percent to about 130 percent the first thickness of the first die.

In some instances, the first die comprises a first area and the second die comprises a second area and the first area of the first die overlaps at least 70 percent of the first area of the first die. In some examples, the second area of the second die overlaps at least 100 percent of the first area of the first die.

In various examples, the first die and the second die are formed from a material having at least one of about a same average coefficient of thermal expansion or about a same average Young's modulus.

In some cases, the first die has a first shape and the second die has a second shape, and the first shape of the first die is about a same shape as a second shape of the second die.

In yet another aspect, an apparatus can include a packaging substrate comprising a first side and a second side opposite the first surface, a first die coupled to the first side of the packaging substrate, the first die comprising a first thickness and a first area, a second die coupled to the second side of the packaging substrate, the second die comprising a second thickness and a second area, a circuit board coupled to the second surface of the packaging substrate comprising a cavity. In some examples, the second die on the second side of the packaging substrate overlaps at least a portion of the first die on the first side of the packaging substrate and the second die is contained within the cavity of the circuit board.

In some instances, the first die comprises a first thickness and a first area and the second die comprises a second thickness and a second area, the first thickness of the first die is about a same thickness as the second thickness of the second die, and the first area of the first die is about a same area as the second area of the second die.

In various cases, the second die includes a via and the via connects a first connection of the circuit board to a second connection of the packaging substrate.

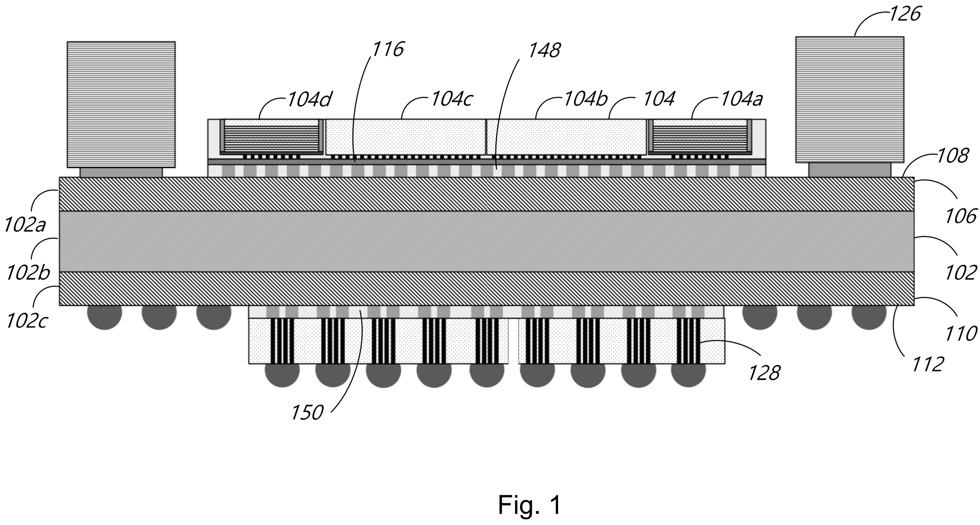

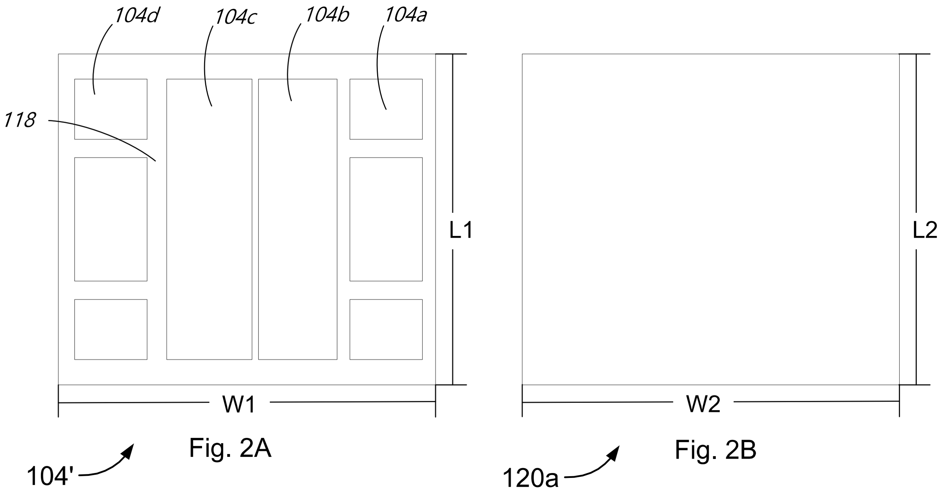

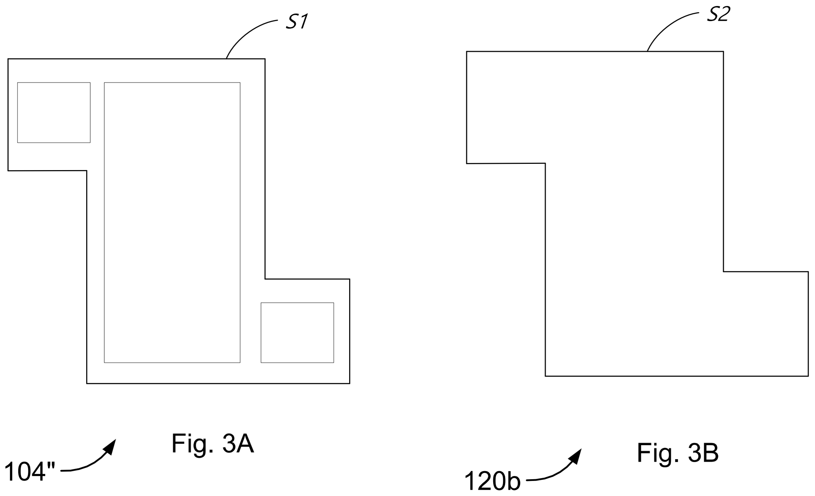

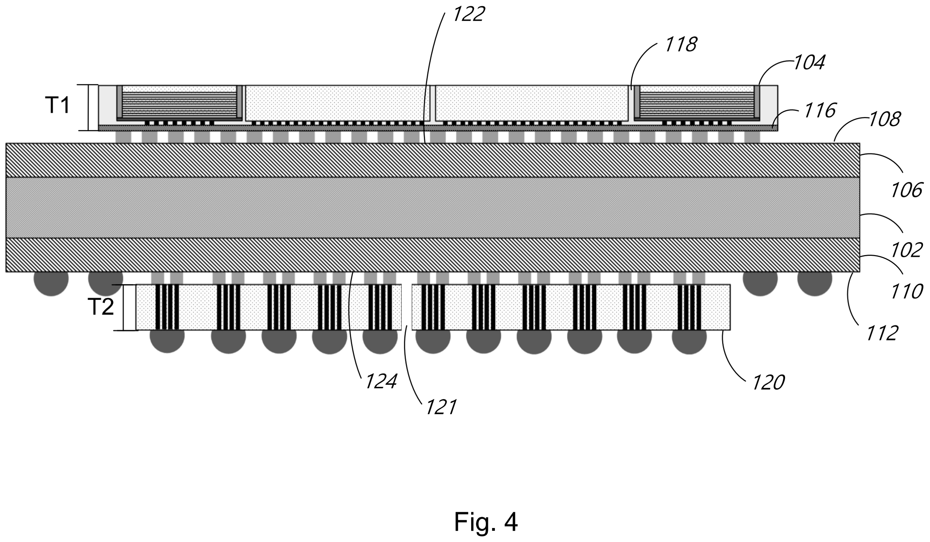

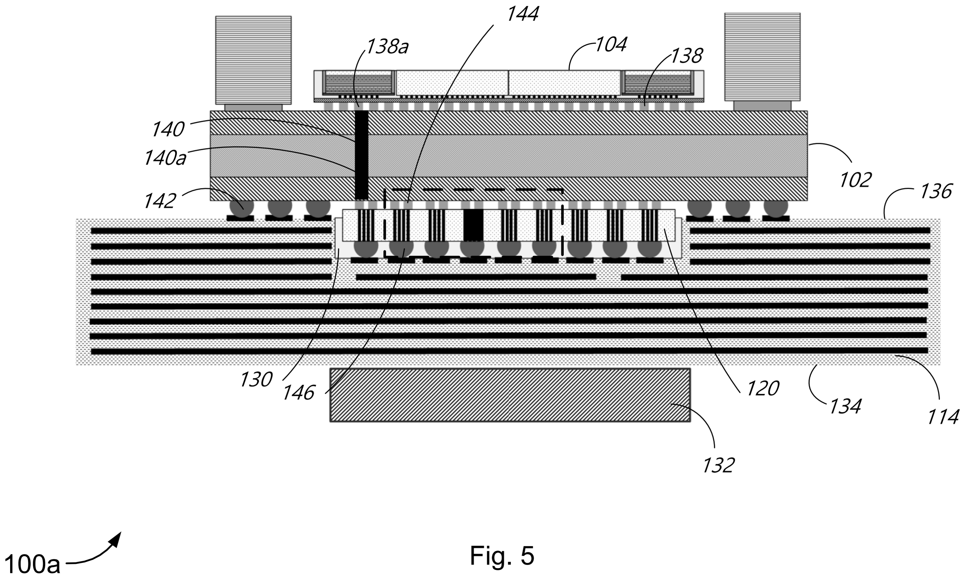

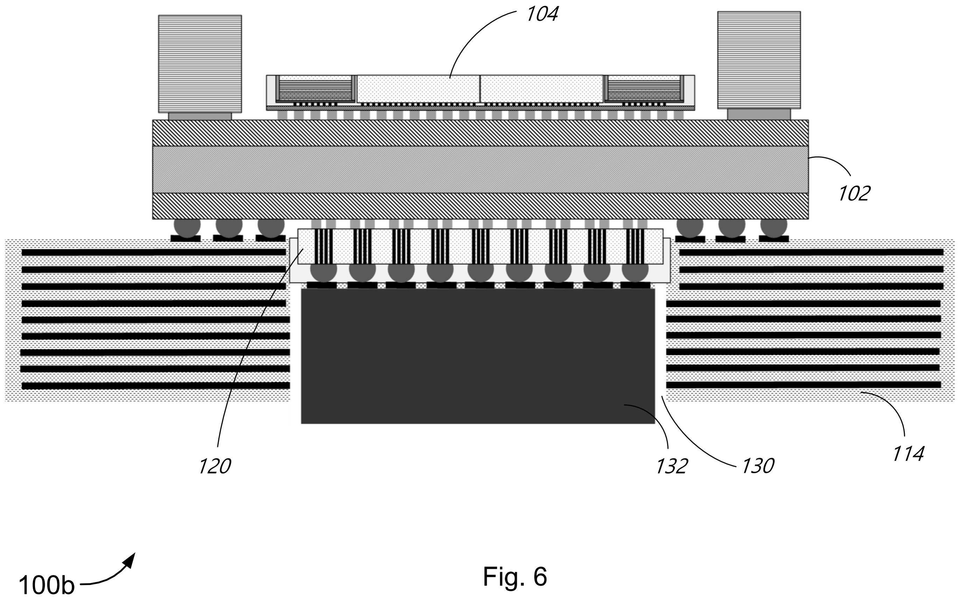

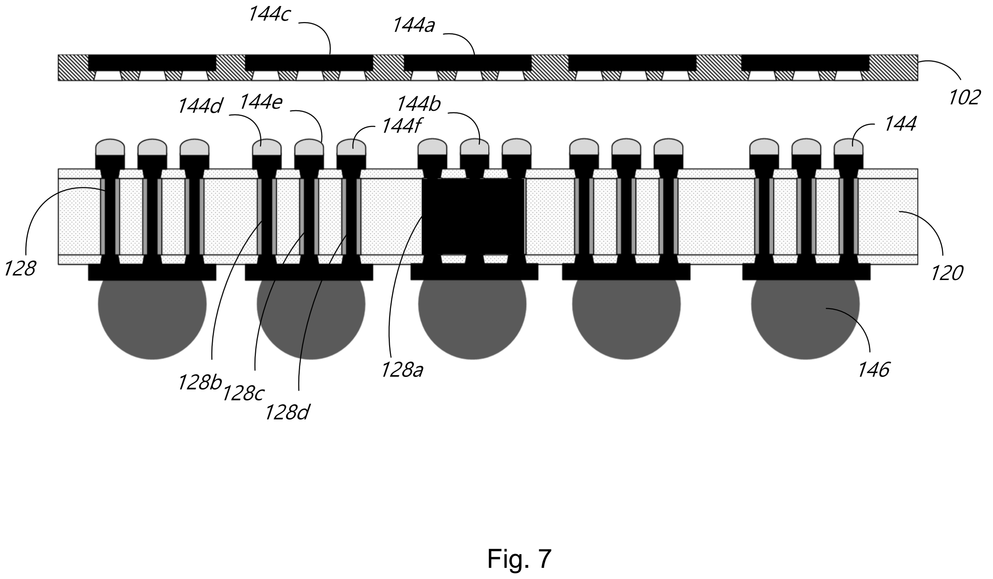

FIGS. 1 and 4 are simplified diagrams illustrating a cross-sectional view of a portion of a semiconductor device 100 according to embodiments of the subject technology. FIGS. 2 and 3 are top views of a functional die and a second die in according to embodiments of the present invention. FIGS. 5 and 6 are simplified diagrams illustrating a cross-sectional view of a semiconductor device 100 according to embodiments of the subject technology. FIG. 7 is a simplified diagram illustrating a cross-sectional view of a portion of a substrate and a second die of a semiconductor device according to embodiments of the subject technology. These diagrams merely provide examples, which should not unduly limit the scope of the claims. One of ordinary skill in the art would recognize many variations, alternatives, and modifications.

As shown, semiconductor device 100 (e.g., semiconductor device 100a of FIG. 5 or semiconductor device 100b of FIG. 6, or the like) includes substrate 102. For example, the term "substrate" may refer to a material or a structure that supports, carries, or couples to other components or devices of the semiconductor device 100. Substrate 102 may be configured to provide mechanical support for other layers or components and form part of one or more electrical and thermal pathways in the semiconductor device 100. In various cases, the substrate 102 could be formed from one or more of silicon, silicon dioxide, ceramics, organic structures, laminated organic structures, glass, and/or any other material or combination of materials.

The substrate 102 can include one or more layers 102a-102c. The one or more layers 102a-102c can include, without limitation, one or more dielectric layers, one or more conducting layers, one or more insulating layers, one or more redistribution layers, and/or the like. The substrate 102 includes a first side 106 having a first surface 108 and a second side 110 having a second surface 112.

Substrate 102 may be a packaging substrate, package substrate, and/or the like. A packaging substrate or package substrate can be a substrate coupled to a backside or a surface of a functional die or a first die or a chip 104 (e.g., functional die 104' of FIG. 2A or functional die 104" of FIG. 3A) at the first side 106 or the first surface 108 and coupled to a front side or a surface of a circuit board 114 at the second side 110 or second surface 112. The packaging substrate can provide structural support and electrical connections to or from the functional die 104. In various cases, the packaging substrate can provide electrical connections to or from the functional die 104 from or to the circuit board 114.

The functional die 104 can include one or more dies or circuits 104a-104d. The functional die 104 can be various shapes or configurations and is should not be limited to only the configurations shown. In some cases, the functional die 104 can be a 2.5D integrated circuit, a 3.5D integrated circuit, or the like. In various cases, the functional die 104 or one or more circuits 104a-104d of the functional die 104 can be configured to perform one or more functions. The one or more functions could include, without limitation, one or more microprocessor functions, one or more switching functions, one or more memory functions, one or more photonic functions, or the like. In some cases, the functional die 104 can include an interposer 116 (e.g., one or more layers configured to electrically connect the one or more circuits 104a-104d to a substrate or another electrical component (e.g., another functional die, another circuit, one or more electrical connections, or the like). In other cases, the interposer 116 might be separate from the functional die 104.

The functional die 104 can be formed from one or more layers including, without limitation, one or more dielectric layers, one or more conducting layers, one or more insulating layers, one or more redistribution layers, one or more device layers, or the like. The functional die 104 can be formed from one or more of silicon, including single crystalline Si and polycrystalline Si.

In various cases, the functional die 104 can include a first area A1. In some cases, the first area A1 can be defined by a first width W1 and a first length L1 of the functional die 104 shown in FIG. 2A. Alternatively, in other cases, the first area A1 can be defined by an area contained within a perimeter of a shape S1 of the functional die 104 as shown in FIG. 3A. In some cases, when the functional die 104 only includes one circuit (e.g., first circuit 104a, or the like), the first area A1 of the functional die 104 might be the area of the circuit (e.g., first circuit 104a, or the like). Alternatively, when the functional die 104 includes two or more circuits (e.g., circuits 102a-102c, or the like), the first area A1 of the functional die 104 can include the area of the two or more circuits (e.g., circuits 102a-102d, or the like) placed side by side on the first side 106 or first surface 108 of the substrate 102. In some cases, the first area A1 can include an area of a space 118 between the one or more circuits 104a-104d or a molding material 118 at least partially surrounding or at least partially encapsulating the one or more circuits 104a-104d. Alternatively, in other cases, the first area A1 can exclude an area of the space 118 between the one or more circuits 104a-104d or the molding material 118 at least partially surrounding the one or more circuits 104a-104d.

The functional die 104 can also have a first thickness T1 shown in FIG. 4. In various cases, the first thickness T1 of the functional die 104 can be defined by a thickness of the thickest circuit 104a-104d. In a non-limiting example, if first circuit 104a is thicker than circuit 104b and 104c, then the first thickness of the functional die 104 will be the thickness of the first circuit 104a. In some cases, the first thickness T1 can include the thickness of the interposer 116. Alternatively, the first thickness T1 can exclude the thickness of the interposer 116. Additionally, in some cases, the first thickness T1 can include a thickness of the molding material 118. Alternatively, the first thickness T1 can exclude the thickness of the molding material 118.

The functional die 104 can have a first average coefficient of thermal expansion (CTE). The average coefficient of thermal expansion of the functional die 104 is the average change in the functional die's size per degree change in temperature. In some cases, the first average coefficient of thermal expansion of the functional die 104 might be the average coefficient of thermal expansion of the one or more circuits 104a-104d. In some cases, the first average coefficient of thermal expansion of the functional die 104 can be calculated based on the one or more circuits 104a-104d and at least one of the interposer 116 or the molding material 118.

The functional die 104 can have a first average Young's modulus. The average Young's modulus of the functional die 104 is a measurement of the functional die's stiffness and elasticity. In some cases, the first average Young's modulus of the functional die 104 might be the average Young's modulus of the one or more circuits 104a-104d. In some cases, the first average Young's modulus of the functional die 104 can be calculated based on the one or more circuits 104a-104c and at least one of the interposer 116 or the molding material 118.

The semiconductor device 100 further includes a second die or additional die 120 (e.g., second die 120a of FIG. 2A, second die 120b of FIG. 3B, or the like). The second die 120 can be coupled to the substrate 102 at the second side 110 or second surface 112 of the substrate 102. In some cases, the functional die 104 can be coupled to a first location or first area 122 of the first side 106 or first surface 108 of the substrate 102 while the second die 120 can be coupled to a second location or second area 124 of the second side 110 or the second surface 112 of the substrate 102. The second location 124 on the second side 110 or the second surface 112 of the substrate 102 corresponds to about a same location as the first location 122 on the first side 106 or the first surface 108 of the substrate 102. In other words, the second location 124 at least partially overlaps at least a portion of the first location 122. In some cases, the second die 120 on the second side 110 or the second surface 112 of the substrate 102 at least partially overlaps the functional die 104 on the first side 106 or first surface 108 of the substrate 102. In some cases, the second die 120 overlaps at least 70 percent of the functional die 104. In some cases, the second die 120 overlaps at least about 100 percent of the functional die 104.

The purpose of the second die 120 is to enhance the mechanical stability of semiconductor device 100. The second die 120 can be used to minimize or reduce deformation of the substrate 102 under thermal and mechanical stresses from the functional die 104 and help maintain the alignment and reliability of package components. In various cases, the second die 120 can be used to provide one or more forces that counterbalance (e.g., counteract, cancel, oppose, or the like) the one or more forces produced by the functional die 104 as the functional die 104 deforms or warps due to thermal changes.

The one or more forces produced by the functional die 104 can be calculated based on one or more of (1) functional die 104's average Young's modulus and CTE across a temperature range, (2) functional die 104's overall area, (3) functional die 104's thickness, or (4) functional die 104's connections to the package substrate through 138 and 148. In some cases, the forces produced by functional die 104 are a summed effect of (1) its average Young's modulus and CTE across a temperature range, (2) its overall area, (3) its thickness, and (4) its connections to the package substrate through 138 and 148.

The counterbalance force from the second die 120 can be calculated based on one or more of (1) second die 120's average Young's modulus and CTE across a temperature range, (2) second die 120's overall area, (3) second die 120's thickness, or (4) second die 120's connections to the package substrate through 144 and 150. In some cases, the counterbalance forces from die 120 are a summed effect of (1) its average Young's modulus and CTE across a temperature range, (2) its overall area, (3) its thickness, and (4) its connections to the package substrate through 144 and 150.

The second die 120 can be formed one or more layers including, without limitation, one or more dielectric layers, one or more conducting layers, one or more insulating layers, one or more redistribution layers, or the like. In some cases, the second die 120 can be formed from one or more of silicon (Si), including single crystalline Si and polycrystalline Si, glass, ceramic, metal, including molybdenum or kovar, or the like.

In various cases, the second die 120 is preferably formed from a same material or composition or a similar material or composition as the functional die 104. A similar material or composition as the functional die 104 might be a material or composition that has at least one of (1) a second average coefficient of thermal expansion that is the same or substantially similar to the first average coefficient of thermal expansion of the functional die 104 or (2) a second average Young's modulus that is the same or substantially similar to the first average Young's modulus of the functional die 104. A material or composition having a substantially similar average coefficient of thermal expansion as the functional die 104 might be a material having variations from the average coefficient of thermal expansion of the functional die 104 of about ± 30%. A material or composition having a substantially similar average Young's modulus as the functional die 104 might be a material having variations from the average Young's modulus of the functional die 104 of about ± 30%.

In various cases, if the functional die 104 is made from silicon or substantially formed silicon, then the second die 120 can be formed of silicon or substantially formed silicon. In some cases, if the functional die 104 is made from single crystalline Si, then the second die 120 can be formed from single crystalline Si or polycrystalline Si, or a combination of single crystalline Si and polycrystalline Si.

By forming the second die 120 from a same or substantially similar material or composition of materials as the functional die 104, several advantages are realized. For example, the second die 120 can be configured to deform or warp in a way that counterbalances the deformation or warpage of the functional die 104. Thus, by including the second die 120 that opposes the deformation or warpage of the functional die 104 on a second side 110 or second surface 112 of the substrate 102, the substrate 102 will deform or warp less as well. Additionally, by using a same or similar material or composition in the second die 120, internal stresses on the substrate 102 will also be reduced because at least one of the average coefficient of thermal expansion or Young's modulus of the material in the second die 120 is substantially similar to the average coefficient of thermal expansion or Young's modulus of the material in the functional die 104.

In various cases, the second die 120 can include a second area A2. In some cases, the second area A2 can be defined by a second width W2 and a second length L2 of the second die 120 shown in FIG. 2B. Alternatively, in other cases, the second area A2 can be defined by an area contained within a perimeter of a second shape S2 of the second die 120 as shown in FIG. 3B. In various cases, the second die 120 can be formed from a single unitary piece as shown in FIG. 1. Alternatively, the second die 120 can be divided into two or more pieces as shown in FIG. 4. In some cases, each piece of the second die 120 can be placed in a location that corresponds to or at least partially or substantially overlaps at least one circuit (e.g., circuits 104a-104d). "Substantially overlaps" as used herein means a perimeter of a component overlaps at least 70 percent of a corresponding component. When the second die 120 is divided into two or more pieces, the second area A2 of the second die 120 can include the area of each piece of the second die located side by side and an area of a molding material 121 or space 121 between each piece of the second die. Alternatively, the second area A2 of the second die 120 can include the area of each piece of the second die 120 located side by side and exclude an area of a molding material or a space between each piece of the second die 120. The second die 120 can also have a second thickness T2.

In order to oppose the deformation or warpage of the functional die 104, the second area A2 of the second die 120 can be about a same area as the first area A1 of the functional die 104. In various cases, about a same area as the first area A1 of the functional die 104 means an area within about 50% to about 130%, inclusive, of the first area A1. Preferably, the second area A2 of the second die 120 is within about 70% to about 130%, inclusive, of the first area A1 of the functional die 104. This allows the second die to better counterbalance the forces of the functional die 104. In some cases, the second area A2 of the second die 120 overlaps at least 70 percent of the first area A1 of the functional die 104 die. In some cases, the second area A2 of the second die 120 overlaps at least about 100 percent of the first area A1 of the functional die 104. This also allows the second die 120 to better counterbalance the forces of the functional die 104.

Additionally, in some cases, the second shape S2 of the second die 120 can be a same shape or about a same shape as the first shape S2 of the functional die 104. About a same shape means that at least one of (1) the perimeter of second shape corresponds to or mirrors or about corresponds to or about mirrors the perimeter of the first shape S2 or (2) the second shape S2 overlaps at least about 50% of the first shape S1 and preferably at least about 70% of the first shape S1. Further, the second thickness T2 of the second die 120 can be about a same thickness as the first thickness T1 of the functional die 104. In various cases, about a same thickness as the first thickness T1 of the functional die 104 means a thickness within about 70% to about 130%, inclusive, of the first thickness T1.

By placing the second die 120 in about a same location on an opposite side or surface of substrate 102 coupled to the functional die 104 and having the second die 120 be one or more of (1) a similar material, (2) about a same area, (3) about a same shape, or (4) about a same thickness as the functional die 104, one or more forces of the functional die 104 on the substrate 102 can be counterbalanced. For example, the second die 120 can be configured to deform or warp in a way that counterbalances the forces of the functional die 104 on the substrate 102. Thus, by including the second die 120 that counterbalances the deformation or warpage of the functional die 104 on a second side 110 or second surface 112 of the substrate 102, the substrate 102 will deform or warp less as well. Additionally, by using (1) a similar material, (2) about a same area, (3) about a same shape, or (4) about a same thickness as the functional die 104, internal stresses on the substrate 102 will also be reduced.

Additionally, the use of the second die 120 on the second side 110 or second surface 112 of the substrate 102 means that a smaller stiffener ring 126 could be used on the first side 106 of the substrate 102 or that no stiffener ring 126 (shown in FIG. 4) could be used on the first side 106 of the substrate 102. This frees up valuable space on the first side 106 of the substrate 102 to include additional circuits or functional dies.

In some cases, second die 120 could include one or more vias 128. The one or more vias 128 can be configured to deliver one or more signals or power to or from the substrate 102 from or to the circuit board 114. In other cases, the second die 120 can include one or more passive components including one or more switches, one or more voltage regulators, one or more capacitors, one or more resistors, one or more inductors, or the like. In some cases, the second die 120 can further include one or more heat dissipation components such as one or more metal layers or pillars.

In various cases, the semiconductor device 100 can further include the circuit board 114 shown in FIGS. 5 and 6. The circuit board 114 could be a printed circuit board (PCB) or the like. The circuit board 114 can be a board configured to facilitate or provide electrical connections between different components of the semiconductor device 100 such as the second die 120, the substrate 102, other substrates, the functional die 104, other functional dies or circuits, or the like.

In various cases, the circuit board 114 can include a cavity 130. The cavity 130 can extend partially through the circuit board 114 as shown in FIG. 5 or the cavity 130 can extend completely through the circuit board 114 as shown in FIG. 6. In some cases, when the cavity 130 extends completely through the circuit board 114, one or more power delivery components or heat dissipation components 132 including one or more traces, interconnects, vias, planes, or the like configured to deliver power or one or more heatsinks or the like configured to dissipate heat can be located within cavity 130 along with the second die 120. Alternatively, when the cavity 130 extends partially through the circuit board 114, one or more power delivery components or heat dissipation components 132 can be located on a backside or surface 134 of the circuit board 114.

The second die 120 can be contained at least partially or fully within the cavity 130 of the circuit board 114. When the second die 120 is contained fully within the cavity 130, a first surface or a top surface 136 of the second die 120 is level with, about level with, or below a first surface or a top surface 136 of the circuit board 114. In some cases, the one or more power delivery components or heat dissipation components 132 can be configured to couple to one or more vias 128 of the second die 120. The vias 128 of the second die can be configured to deliver power from the circuit board 114 to the substrate 102 using one or more vias 128 of the second die 120.

In various cases, the functional die 104 can be coupled to the first side 106 or the first surface 108 of the substrate by one or more first connections 138. The one or more first connections 138 might include one or more of pads, bumps, vias, or the like. In various cases, FIG. 5 shows one or more bumps 138a connecting the functional die 104 to the substrate 102. The first connections 138 can be coupled to one or more second connections 140 of the substrate 102. The one or more second connections 140 might include one or more of pads, bumps, vias, or the like. In this case, one or more bumps 138a can be coupled to one or more corresponding vias 140a contained within the substrate 102. In some cases, a pad or other connection can be used to couple the one or more bumps 138a to one or more corresponding vias 140s.

The second side 110 or second surface 112 of the substrate 102 can be coupled to the circuit board 114 by one or more third connections 142. The one or more third connections 142 can be configured to couple the substrate 102 or the second surface 112 of the substrate 102 directly (e.g., without an intervening substrate between substrate 102 and circuit board 114, without an intervening die between substrate 102 and circuit board 114, or the like) to the circuit board 114, a top surface 136 of the circuit board 114, or a component of the circuit board 114 including a pad, ball grid array, or the like. The one or more third connections 142 might include one or more of pads, bumps, vias, or the like. The second side 110 or the second surface 112 of the substrate 102 can also be coupled to the second die 120 by one or more fourth connections 144. The one or more fourth connections 144 can be configured to couple the substrate 102 or the second surface 112 of the substrate 102 directly (e.g., without an intervening substrate between substrate 102 and second die 120, without an intervening die between substrate 102 and second die 120, or the like) to the second die 120, a surface of the second die, or a component of the second die including a pad, ball grid array, or the like. The one or more fourth connections 144 can include one or more of pads, bumps, vias, or the like.

The second die 120 can be coupled to the circuit board 114 by one or more fifth connections 146. The one or more fifth connections 146 can be configured to couple the second die 120 or a surface of the second die 120 directly (e.g., without an intervening substrate between second die 120 and circuit board 114, without an intervening die between second die 120 and circuit board 114, or the like) to the circuit board 114, a bottom surface of the cavity 130 of the circuit board 114, or a component of the circuit board 114 including a pad, ball grid array, or the like. The one or more fifth connections 146 might include one or more of pads, bumps, vias, or the like.

In some instances, as shown in FIG. 7, the one or more fourth connections 144 can be coupled to one or more vias 128 of the second die 120. In some examples, one via 128a can be coupled to a corresponding pad 144a using one or more bumps 144b. In other examples, each via of two or more vias (e.g., vias 128b-128d, or the like) can be coupled to a single corresponding pad 144c by a corresponding one or more bumps (e.g., bumps 144d-f).

In order to provide a second die 120 that counterbalances the forces or stresses caused by the functional die 104, the one or more fourth connections 144 provided between the substrate 102 and the second die 120 might be similar to the one or more first connections 138 provided between the substrate 102 and the functional die 104. For example, in order to be similar, the fourth connections 144 might be one or more of (1) about a same number or amount as the first connections 138, (2) about a same size (e.g., have one or more of about a same width, about a same length, about a same area, or about a same thickness) as the first connections 138, (3) at least partially located on the second side 110 or second surface 112 or in about a same location as the first connections 138 on the first side 106 or first surface 108 of the substrate 102, or (4) formed from a same material as the first connections 138.

In some cases, an underfill or molding material 148 might be inserted between the functional die and the substrate 102 to at least partially or fully encapsulate the one or more first connections 138 as shown in FIG. 1. An underfill or molding material 150 might be inserted between the second die 120 and the substrate 102 to at least partially or fully encapsulate the one or more fourth connections 144 as shown in FIG. 1. In various cases, the underfill or molding material 150 provided between the substrate 102 and the second die 120 might be similar to the underfill or molding material 148 provided between the substrate 102 and the functional die 104. For example, in order to be similar, the underfill or molding material 150 might be one or more of (1) about a same size (e.g., have one or more of about a same width, about a same length, about a same area, or about a same thickness) as the underfill or molding material 148, (2) at least partially located on the second side 110 or second surface 112 or in about a same location as the underfill or molding material 148 on the first side 106 or first surface 108 of the substrate 102, or (3) formed from a same material as the underfill or molding material 148.

By having the same or similar fourth connections 144 or the same or similar underfill material 150 as the functional die 104, the second die 120 will deform or warp in a similar manner as the functional die 104. This allows the second die 120 to counterbalance the thermomechanical stresses caused by the functional die 104 and reduce the stresses on the substrate 102. By reducing the stresses on the substrate 102, misalignment of components and potential electrical failures are less likely to occur in semiconductor device 100.

It is to be appreciated that semiconductor device 100 incorporates second die 120 that is at least one of (1) about a same thickness as the functional die 104, (2) about a same area as the functional die 104, (3) in about a same location as the functional die 104, or (4) formed from a similar material as the functional die 104. Providing the second die on the second side of the substrate counterbalances the thermomechanical stresses or forces produced by the first die. Thus, reducing the stresses on the substrate than can cause misalignment between semiconductor components or electrical failures. In some cases, with the added second die 120, the warpage of the semiconductor device 100 at room temperature can be reduced at least about 35 percent while the warpage of the semiconductor device 100 at high temperature can be reduced at least about 30 percent.

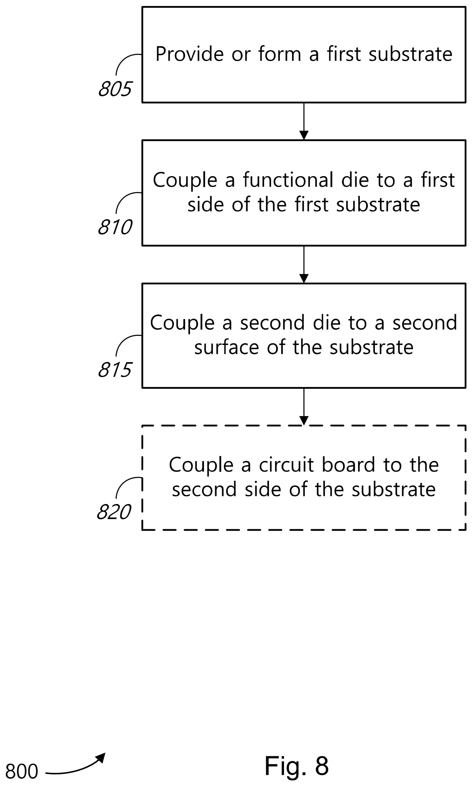

Figure 8 is a block diagram illustrating method 800 for fabricating a semiconductor device according to embodiments of the subject technology. These diagrams merely provide an example, which should not unduly limit the scope of the claims. One of ordinary skill in the art would recognize many variations, alternatives, and modifications.

In various implementations, method 800 may be used to fabricate semiconductor devices, such as semiconductor device 100 or portions of semiconductor device 100 illustrated in Figures 1-7, which can be applied across a wide range of applications, including high-power electronics, large-scale packages, high-density integrated circuits, and/or the like. In some embodiments, method 800 may include at block 805 (e.g., manual operation or machine operation) providing a substrate (e.g., substrate 102 or the like). The method 800 may also include, at block 810, coupling a functional die (e.g., functional die 104 or the like) to a first side of the substrate. Next, at block 815, the method 800 can include coupling a second die (e.g., second die 120 or the like) to a second side of the substrate opposite the first side. The method 800, at optional block 820, can further include coupling a circuit board (e.g., circuit board 114 or the like) to the second side.

While the above is a full description of the specific embodiments, various modifications, alternative constructions and equivalents may be used. Therefore, the above description and illustrations should not be taken as limiting the scope of the subject technology which is defined by the appended claims.

## Claims

1. An apparatus comprising:
a packaging substrate comprising a first side and a second side opposite the first side;
a first die coupled to the first side of the packaging substrate, the first die comprising a first thickness and a first area; and
a second die coupled to the second side of the packaging substrate, the second die comprising a second thickness and a second area, wherein:
the second die on the second side of the packaging substrate overlaps at least a portion of the first die on the first side of the packaging substrate;
the first thickness of the first die is about a same thickness as the second thickness of the second die; and
the first area of the first die is about a same area as the second area of the second die.

2. The apparatus of claim 1, wherein
the first die and the second die are formed from a same material.

3. The apparatus of claim 1 or 2, wherein
the first die and the second die are at least one of formed from a material having about a same average coefficient of thermal expansion or formed from a material having at least of about a same average Young's modulus.

4. The apparatus of any one of the claims 1 to 3, wherein
the second die on the second side of the packaging substrate overlaps at least 70% of the first die on the first side of the packaging substrate.

5. The apparatus of any one of the claims 1 to 4, wherein
the second die comprises one or more vias.

6. The apparatus of any one of the claims 1 to 5, wherein
the first die is coupled to the packaging substrate via a first connection, wherein the second die is coupled to the packaging substrate via a second connection, wherein the first connection and the second connection are about a same size;
wherein in particular
the first connection is encapsulated in a first molding material, wherein the second connection is encapsulated in a second molding material, wherein the second molding material is about a same size as the first molding material.

7. The apparatus of any one of the claims 1 to 6, wherein
the first die is coupled to the packaging substrate via a first connection, wherein the second die is coupled to the packaging substrate via a second connection, wherein the first connection is located in about a same location as the second connection.

8. The apparatus of any one of the claims 1 to 7, wherein
the second die is separated into multiple parts;
or
the second die is formed of a unitary part.

9. The apparatus of any one of the claims 1 to 8, wherein
the first die is formed of single crystalline silicon and the second die is formed of single crystalline silicon or polycrystalline silicon.

10. An apparatus comprising:
a packaging substrate comprising a first side and a second side opposite the first side; a first die coupled to the first side of the packaging substrate, the first die comprising a first thickness; and
a second die coupled to the second side of the packaging substrate, the second die comprising a second thickness, wherein:
the second thickness of the second die is about 70 percent to about 130 percent the first thickness of the first die.

11. The apparatus of claim 10, wherein
the first die comprises a first area and the second die comprises a second area and wherein the first area of the first die overlaps at least 70 percent of the first area of the first die;
wherein in particular
the second area of the second die overlaps at least 100 percent of the first area of the first die.

12. The apparatus of claim 10 or 11, wherein
the first die and the second die are formed from a material having at least one of about a same average coefficient of thermal expansion or about a same average Young's modulus;
and/or
the first die has a first shape and the second die has a second shape, and wherein the first shape of the first die is about a same shape as a second shape of the second die.

13. An apparatus comprising:
a packaging substrate comprising a first side and a second side opposite the first side; a first die coupled to the first side of the packaging substrate, the first die comprising a first thickness and a first area;
a second die coupled to the second side of the packaging substrate, the second die comprising a second thickness and a second area; and
a circuit board coupled to the second side of the packaging substrate comprising a cavity, wherein:
the second die on the second side of the packaging substrate overlaps at least a portion of the first die on the first side of the packaging substrate; and
the second die is contained within the cavity of the circuit board.

14. The apparatus of claim 13, wherein
the first die comprises a first thickness and a first area and the second die comprises a second thickness and a second area, the first thickness of the first die is about a same thickness as the second thickness of the second die, and the first area of the first die is about a same area as the second area of the second die.

15. The apparatus of claim 13 or 14, wherein
the second die comprises a via;
wherein in particular
the via connects a first connection of the circuit board to a second connection of the packaging substrate.
